(19) Europäisches Patentamt
European Patent Office
Office européen des brevets

(11) Publication number: **0 135 624**
**B1**

(12) **EUROPEAN PATENT SPECIFICATION**

(45) Date of publication of patent specification: **27.01.88**

(51) Int. Cl.$^4$: **H 03 F 1/18**

(21) Application number: **83305106.3**

(22) Date of filing: **02.09.83**

(54) **High power amplifier arrangement.**

(43) Date of publication of application:
**03.04.85 Bulletin 85/14**

(45) Publication of the grant of the patent:
**27.01.88 Bulletin 88/04**

(84) Designated Contracting States:
**AT BE CH DE FR IT LI LU NL SE**

(56) References cited:
**EP-A-0 012 093**
**GB-A- 963 185**
**GB-A-1 235 473**
**US-A-3 593 174**
**US-A-3 701 038**
**US-A-3 747 006**
**US-A-4 097 814**
**US-A-4 263 559**

(73) Proprietor: **THE MARCONI COMPANY LIMITED**
**The Grove Warren Lane**
**Stanmore Middlesex HA7 4LY (GB)**

(72) Inventor: **Gerard Roger Edwin John**
**23, Romans Way**
**Writtle Chelmsford Essex, CM1 3EZ (GB)**

(74) Representative: **Hoste, Colin Francis et al**
**The General Electric Company p.l.c. Central Patent Department (Chelmsford Office) Marconi Research Centre West Hanningfield Road**
**Great Baddow Chelmsford CM2 8HN, Essex (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 135 624 B1

Courier Press, Leamington Spa, England.

**Description**

This invention relates to high power amplifier arrangements which are suitable for the amplification of electrical signals having frequencies which extend over a wide band. It is often necessary to provide a greater output power than can be generated by a single amplifier device, and thus a number of such devices are used in combination so that together the total power handling requirement can be met.

One form of high power amplifier arrangement which is capable of operating over a wide frequency band is that known as a distributed amplifier. Such amplifiers are particularly suitable for use with vacuum valves, as they take advantage of the valve electrode capacitances which are arranged to form part of input and output delay lines. Distributed amplifiers are described in our earlier U.K. patents 846,633 and 2,040,635B.

A disadvantage which can arise with a distributed amplifier is that, if it operates into a mismatched load, the voltage which builds up on the output delay line can be unacceptably high, and thus to allow for this possibility it may be necessary to operate such an amplifier at well below its theoretically possible maximum rating. The present invention seeks to provide an improved high power amplifier arrangement.

According to this invention an amplifier arrangement includes a plurality of amplifying devices having their individual input terminals connected to different points along an input delay line which has a predetermined passband; and the output terminals of the amplifying devices being connected to different points along an output delay line, said points along the output line being so chosen that delays between said output terminals are substantially the same as the delays between the corresponding input terminals; characterised in that the output delay line consists of separate sequentially connected stages each of which comprises a power combiner and a delay stage having a predetermined passband, the impedances of said delay stages progressively reducing towards the output point at one end of the output line; the power combiners being arranged to couple power from a respective amplifying device into said output line, each power combiner incorporating a load in which power is dissipated only if the power fed to the two inputs of the power combiner are not in a predetermined proportion and phase.

Preferably each amplifying device is arranged to present to the power combiner an output impedance which is matched to the impedance of the output line.

Preferably again each amplifying device includes a solid state amplifying element having a mainly capacitive input impedance.

The invention is further described by way of example with reference to the accompanying drawings, in which:

Figure 1 shows in schematic form a high power amplifier arrangement in accordance with the invention,

Figure 2 shows one form of the arrangement in greater detail,

Figure 3 shows a power combiner forming part of Figure 2 in greater detail,

Figure 4 shows an alternative form of an individual amplifying device, and

Figure 5 shows a modified power combiner adapted for push-pull operation.

The invention is particularly suitable for amplifying a wideband electrical signal. The use of a distributed amplifier to amplify wideband high frequency signals, enables the gain to be increased, as it would otherwise be unacceptably low due to capacitance effects of the active amplifying devices used. In a distributed amplifier of the kind described for example in our U.K. Patent 846,633, all of the amplifying devices act together, so as to constitute, in effect, a single amplifier and the correct phasing is preserved between the different amplifying devices by providing input and output delay lines having the correct passband and delay characteristics.

With valves both the input capacitance and the output capacitance limit gain. With field effect transistors it is mainly the input capacitance which is responsible for keeping the gain low, but being a low impedance device the capacitance associated with the output terminal does not generally have significant effect on the gain. In the illustrated embodiments of this invention, a number of amplifying devices are driven from the same input voltage. As the output power from the separate devices is summed, the overall gain of the combination is increased as the number of devices is increased.

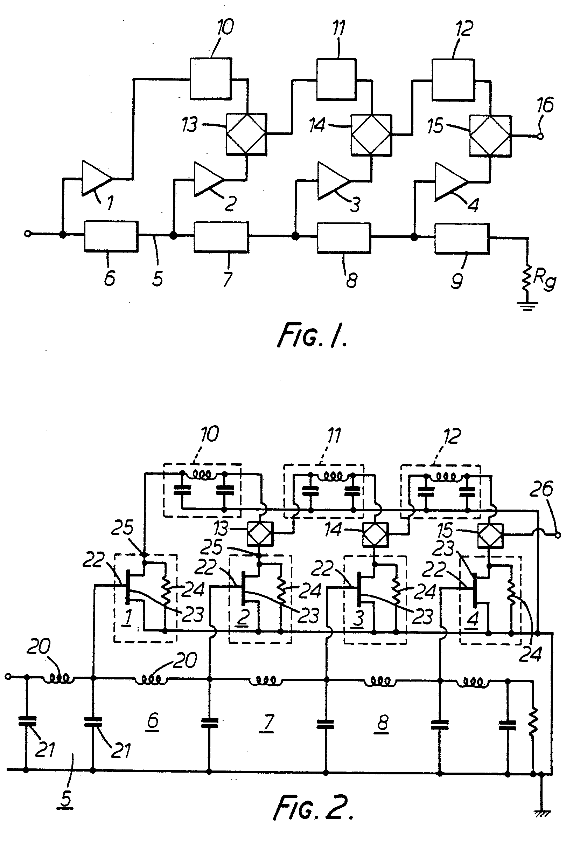

Figure 1 shows a high power amplifier arrangement in accordance with the invention, and which has a configuration related to that of a distributed amplifier, but it differs in that the outputs of the individual amplifying devices are fed independently on to an output line consisting of separate and independent delay stages. In Figures 1, four individual amplifying devices 1, 2, 3 and 4 are connected in parallel and their input terminals are connected to respective points along an input delay line 5. In practice, the input delay line 5 is divided up into stages 6, 7 and 8, 9, but it behaves as a single unitary transmission line. Each of the amplifier devices 1, 2, 3 and 4 has an extremely high input impedance, so that essentially very little power is drawn from the input delay line, and it is not necessary to control the relative proportions of the total power which is drawn by the individual amplifying devices. Power incident on the input terminals travels along the delay line driving each active element in succession without loss, and is finally absorbed in the terminating resistance Rg. Thus all stages are driven to the same amount. Thus the input delay line 5 is identical to that of the conventional distributed amplifier. However, the output line of the amplifier consists of a number of separate delay stages 10, 11 and 12, which are quite distinct from each other and which are spaced apart by respective power combiners 13, 14 and 15. Furthermore, each amplifying device 1, 2, 3 and 4 is arranged such that it presents a predetermined matched output impedance to the power combiners. The matched output impedance could take the form of a basic resistive element, or could be simulated by other techniques such as described in our patent 1,088,251. The delay characteristics of the delay stages 10, 11 and 12 are arranged such that the outputs of the different amplifying devices combine constructively, and thus, in practice, the overall delay provided by the output line is the same as that provided by the input delay line 5.

If the arrangement shown in Figure 1 feeds via an output port 16 into an antenna, or other utilisation device, having an impedance which is matched to the output impedance of the amplifier arrangement, the whole of the power will be transferred to the antenna. If, however, the two impedances are not perfectly matched, some power will be reflected back along the output delay line to the amplifying devices. In the case of the previously known distributed amplifiers, this reflected power causes high voltages to be generated along the line, with the voltage increasing with distance from the output point. The use, in this invention, of the power combiners 13, 14 and 15, together with the matched output impedance of the amplifying devices 1, 2, 3 and 4 ensures that reflected power is fed back equally to, and is absorbed by, the output impedance 24 of each amplifying device.

By way of contrast with conventional distributed amplifiers, it will be noted that no termination impedance is provided at the end of the output line which is remote from the output point apart from that associated with the first amplifying device — this avoids unnecessary dissipation of power.

The invention is particularly suitable for use with amplifying devices, which either consist wholly of field effect transistors (FET) or comprise composite devices having an FET input stage and FET or bipolar output stage. As is well known, an FET device has an extremely high input impedance, which is predominantly capacitive. Therefore its input capacitance can be so designed as to form an integral part of a loss-less input delay line 5.

Figure 2 shows in greater detail an amplifier having four individual amplifying devices, which are constituted as FET elements. So far as possible, the same reference numerals as Figure 1 are used. The input delay line 5 consists of a number of individual stages comprising series inductors 20 and shunt capacitors 21. The gate electrodes 22 of FET 23 are connected to successive stages of the input delay line 5 in such a way that the gate capacitances of the FETs form part of the shunt capacitance 21 of the delay line. Each amplifying device 1, 2, 3 and 4 consists of a similar FET 23, and a resistance 24 which is connected between the source and drain electrodes, so as to enable the amplifying device to present a predetermined output impedance at its output terminal 25. The actual value of the resistance 24 determines the output impedance, which in this example is 50Ω for each amplifying device. The first amplifying device 1 feeds directly into the first delay stage 10, which is designed to exhibit a characteristic impedance of 50Ω. The output of the delay stage 10 is fed to a power combiner 13, having a second input which receives the output of the second amplifying device 2. Thus each input has a characteristic impedance of 50Ω and the combiner is arranged to have an output impedance of 25Ω, which feeds into the second delay stage 11 which itself had an equal characteristic impedance of 25Ω. The second combiner 14 has one input impedance of 25Ω, which is connected to the delay stage 11 and a second input impedance of 50Ω, which is connected to the output point of the third amplifying device 3. The third delay stage 12 has an impedance of 16.7Ω and this of course, corresponds to one input impedance of the final power combiner 15. The other input of the power combiner has the input impedance of 50Ω, so that the output impedance of the combiner 15 is 12.5Ω. The asymmetrical impedance of the power combiners 14 and 15 ensures that power is combined in the correct proportion, so that overall each of the four amplified devices 1, 2, 3 and 4 contributes the same amount of power to the output point 26. Thus each combiner (13, 14, 15) has a different coupling ratio. Hence the impedance of the output line decreases progressively towards the output point 26. Any number of devices may be combined by this technique.

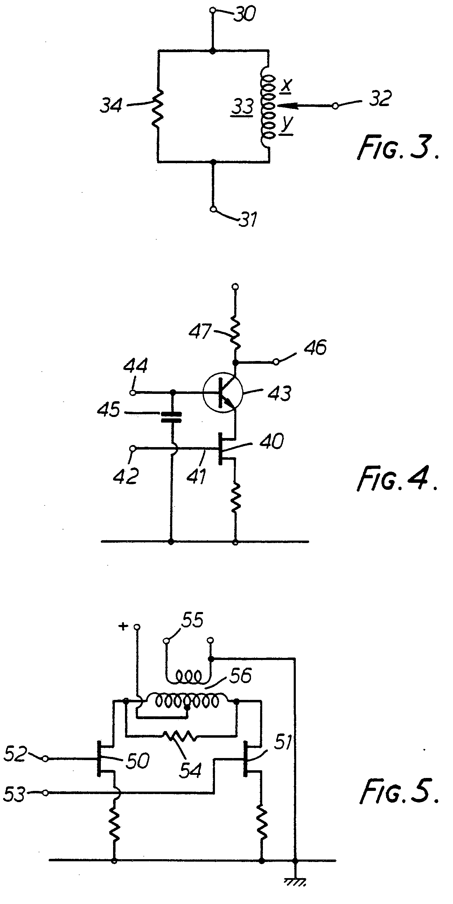

The nature of each power combiner 13, 14, 15 is more clearly indicated in Figure 3. It has two input terminals 30, 31 and a single output terminal 32, and consists of a transformer 33 in shunt with a resistance 34. The combiner is essentially a hybrid transformer, in which under ideal conditions, the relative impedances x, y of the transformer windings on either side of the output tap point, are in the same proportion as the impedances of the external circuits connected to terminals 30, 31. Thus it acts to combine power in the correct proportion from the circuits external to it. If however, the power supplied is not in the correct balance, or is received via the output terminal 32, the out of balance power is dissipated within the resistance 34. Under ideal operating conditions essentially no power is lost in this resistance 34.

The circuit shown in Figure 2 has a number of advantages as compared with a conventional distributed amplifier. For example, the failure of any one of the amplifying devices does not result in the complete failure of the whole amplifying arrangement. Instead, it can continue to operate at reduced power without serious degradation of performance. The percentage reduction of power output for the composite amplifier when operating into a mis-matched load is the same as for a single amplifying device.

Although, in Figure 2, each amplifying device is shown as consisting only of an FET active element, other possibilities exist. In Figure 4, a cascode amplifier device is illustrated in which an FET 40 has a gate electrode 41, connected to the input delay line 5, via a terminal 42. The FET 40 forms part of a cascode configuration, which also includes a bipolar transistor 43. In the manner of conventional cascode amplifiers, the base terminal of the bipolar transistors 43 receives a constant bias potential, via a terminal 44, which is capacitively connected to ground via a capacitor 45. The output of the amplifier device is taken from point 46, which is positioned between the collector of the bipolar transistor 43 and a source resistor 47, which determines the output impedance of the amplifying device as a whole.

Distortion due to second harmonics can be cancelled by a push-pull configuration. A suitable layout for an amplifying stage is shown in Figure 5, in which each amplifier has a balanced input and an unbalanced output. Thus such an amplifier arrangement has two input delay lines, but only a single output line. The two FETs 50 and 51 are connected to respective input delay lines via terminals 52, 53, and a source resistance 54 ensures that a matched output impedance is supplied to an output terminal 55. The transformer 56 combines the outputs of the FETs 50, 51. Each stage of the kind shown in Figure 5 would be coupled onto an output line consisting of delay stages separated by power combiners, in an analogous manner to Figure 1.

**Claims**

1. An amplifier arrangement including a plurality of amplifying devices (1, 2, 3, 4) having their individual input terminals connected to different points along an input delay line (5) which has a predetermined passband; and the output terminals of the amplifying devices being connected to different points along an output delay line (10—15), said points along the output line being so chosen that delays between said output terminals are substantially the same as the delays between the corresponding input terminals; characterised in that the output delay line consists of separate sequentially connected stages each of which comprises a power combiner (13, 14, 15) and a delay stage (10, 11, 12) having a predetermined passband, the impedances of said delay stages (10, 11, 12) progressively reducing towards the output point (16) at one end of the output line; the power combiners (13, 14, 15) being arranged to couple power from a respective amplifying device (1, 2, 3, 4) into said output line, each power combiner incorporating a load (24) in which power is dissipated only if the power fed to the two inputs of the power combiner are not in a predetermined proportion and phase.

2. An arrangement as claimed in claim 1 and wherein each amplifying device (1, 2, 3, 4) is arranged to present a predetermined output impedance which is matched to the appropriate impedance value of the output line.

3. An arrangement as claimed in claim 1 and wherein the power combiners (13, 14, 15) are arranged so that each amplifying device feeds the same power level on to the output line.

4. An arrangement as claimed in claim 1, and wherein each amplifying device (1, 2, 3, 4) includes an active amplifier element (23) having a predominantly capacitive input impedance.

5. An arrangement as claimed in claim 4 and wherein said active amplifier elements are field effect transistors (23).

6. An arrangement as claimed in claim 1 and wherein each power combiner (13, 14, 15) includes a transformer winding (56) in shunt with a resistance (54) in which power is dissipated only if the powers fed to two inputs of the power combiner are not in a predetermined proportion and phase.

7. An arrangement as claimed in claim 6 and wherein the two ends of the transformer winding (56) constitute the two inputs of the power combiner, and its output is provided by a tap point on the winding, the position of the tap point along the winding determining the relative magnitudes of the powers accepted at its two inputs.

**Patentansprüche**

1. Verstärkereinrichtung mit einer Vielzahl von verstärkenden Bauteilen (1, 2, 3, 4), deren einzelne Eingangsklemmen an verschiedenen Stellen längs einer Eingangs-Verzögerungsleitung (5) mit einem vorbestimmten Durchlaßband angeschlossen sind; und bei der die Ausgangsklemmen der verstärkenden Bauteile an verschiedenen Stellen längs einer Ausgangs-Verzögerungsleitung (10—15) angeschlossen sind, wobei die Stellen längs der Ausgangsleitung so ausgewählt sind, daß Verzögerungen zwischen den Ausgangsklemmen im wesentlichen die gleichen wie die Verzögerungen zwischen den entsprechenden Eingangsklemmen sind, dadurch gekennzeichnet, daß die Ausgangs-Verzögerungsleitung aus separaten hintereinander angeschlossenen Stufen besteht, die jeweils einen Leistungs-Koppler (13, 14, 15) und eine Verzögerungsstufe (10, 11, 12) mit einem vorbestimmten Durchlaßband umfassen, wobei die Impedanzen der Verzögerungsstufen (10, 11, 12) fortschreitend zu der Ausgangsstelle (16), an einem Ende der Ausgangsleitung hin abnehmen; die Leistungskoppler (13, 14, 15) zum Koppeln von Leistung von einem jeweiligen verstärkenden Bauteil (1, 2, 3, 4) in die Ausgangsleitung angeordnet sind, wobei jeder Leistungskoppler eine Last (24) enthält, in der Leistung nur verbraucht wird, wenn die den beiden Eingängen des Leistungskopplers zugeführten Leistungen nicht in einer vorbestimmten Proportion und Phase sind.

2. Einrichtung nach Anspruch 1, und bei der jedes verstärkende Bauteil (1, 2, 3, 4) ausgelegt ist, eine vorbestimmte Ausgangsimpedanz zu zeigen, die an den zugehörigen Impedanzwert der Ausgangsleitung angepaßt ist.

3. Einrichtung nach Anspruch 1, und bei der die Leistungskoppler (13, 14, 15) so angeordnet sind, daß jedes verstärkende Bauteil den gleichen Leistungspegel zu der Ausgangsleitung zuspeist.

4. Einrichtung nach Anspruch 1, und bei der jedes verstärkende Bauteil (1, 2, 3, 4) ein aktives Verstärkerelement (23) mit einer vorwiegend kapazitiven Eingangsimpedanz enthält.

5. Einrichtung nach Anspruch 4, und bie der die aktiven Verstärkerelemente Feldeffekttransistoren (23) sind.

6. Einrichtung nach Anspruch 1, und bei der jeder Leistungskoppler (13, 14, 15) eine Transformatorwicklung (56) im Nebenschluß zu einem Widerstand (54) enthält, in welchem Leistung nur verbraucht wird, falls die den beiden Eingängen des Leistungskopplers zugeführten Leistungen nicht in vorbestimmter Proportion und Phase sind.

7. Einrichtung nach Anspruch 6, und bie der die beiden Enden der Transformatorwicklung (56) die beiden Eingänge des Leistungskopplers bilden, und sein Ausgang durch eine Anzapfstelle an der Wicklung geschaffen ist, wobei die Lage der Anzapfstelle längs der Wicklung die relativen Größen der an den beiden Eingängen empfangenen Leistungen bestimmt.

**Revendications**

1. Disposition d'amplificateurs comprenant plusiers dispositifs d'amplification (1, 2, 3, 4) ayant leurs bornes d'entrée individuelles connectées à des point différents le long d'une ligne à retard d'entrée (5) qui a une bande passante prédéterminée; et les bornes de sortie des dispositifs d'amplification étant connectées à des points différents le long d'une ligne à retard de sortie (10—15), lesdits points le long de la ligne de sortie étant choisis de manière que les retards entre lesdites bornes de sortie soient pratiquement les mêmes que les retards entre les bornes d'entrée correspondantes; caractérisée en ce que la ligne à retard de sortie consiste en des étages séparés connectés séquentiellement dont chacun consiste en un combineur de puissance (13, 14, 15) et un étage de retard (10, 11, 12) ayant une bande passante prédéterminée, l'impédance desdits étages de retard (10, 11, 12) diminuant progressivement vers le point de sortie (16) à une extrémité de la ligne de sortie; les combineurs de puissance (13, 14, 15) étant agencés pour coupler de la puissance provenant d'un dispositif d'amplification respectif (1, 2, 3, 4) avec ladite ligned de sortie, chaque combineur de puissance comprenant une charge (24) dans laquelle de la puissance n'est dissipée que si les puissances fournies aux deux entrées du combineur de puissance ne sont pas dans des proportions et des phases prédéterminées.

2. Disposition selon la revendication 1, et dans laquelle chaque dispositif d'amplification (1, 2, 3, 4) est agencé pour présenter une impédance de sortie prédéterminée qui est adaptée à la valeur d'impédance appropriée de la ligne de sortie.

3. Disposition selon la revendication 1, et dans laquelle les combineurs de puissance (13, 14, 15) sont agencés de manière que chaque dispositif d'amplification fournisse le même niveau de puissance sur la ligne de sortie.

4. Disposition selon la revendication 1, et dans laquelle chaque dispositif d'amplification (1, 2, 3, 4) comporte un élément amplificateur actif (23) ayant une impédance d'entrée à prédominance capacitive.

5. Disposition selon la revendication 4, et dans laquelle lesdits éléments amplificateurs actifs sont des transistors à effet de champ (23).

6. Disposition selon la revendication 1 et dans laquelle chaque combineur de puissance (13, 14, 15) comporte un enroulement de transformateur (56) en dérivation avec une résistance (54) dans laquelle une puissance est dissipée seulement si les puissances fournies aux deux entrées du combineur de puissance ne sont pas dans des proportions et des phases prédéterminées.

7. Disposition selon la revendication 6, et dans laquelle les deux extrémités de l'enroulement de transformateur (56) constituent les deux entrées du combineur de puissance et sa sortie est formée par un point médian sur l'enroulement, la position du point médian le long de l'enroulement déterminant les amplitudes relatives des puissances acceptées à ses deux entrées.

10
11
12
13
14
15
16
1
2
3
4
6
5
7
8
9
Rg
FIG. 1.

10
11
12
26
13
14
15
25
25
23
22
22
22
22
24
24
24
23
23
23
1
2
3
4
24
20
20
6
7
8
21
21
5
FIG. 2.

30
34
33
x
y
32
31
FIG. 3.

47
46
44
43
45
40
42
41
FIG. 4.

+
55
56
51
52
50
54
53
FIG. 5.